# EUROPEAN PATENT APPLICATION

(11) **EP 2 133 908 A1**
(43) Date of publication of application: **16.12.2009**
(21) Application number: 07828094.8
(22) Date of filing: 29.11.2007
(51) Int. Cl.: H01L 21/205, H01L 21/02, H01L 27/12

(54) **METHOD FOR MANUFACTURING DEFORMATION SILICON SUBSTRATE**

(30) Priority: 19.12.2006 JP 2006341799
(71) Applicant: Shin-Etsu Handotai Co., Ltd., Tokyo 100-0004 (JP)
(72) Inventor: OKA, Satoshi, Annaka-shi Gunma 379-0125 (JP); NOTO, Nobuhiko, Annaka-shi Gunma 379-0125 (JP)
(74) Representative: Wibbelmann, Jobst
(86) International application number: PCT/JP2007/001317
(87) International publication number: WO 2008/075449

(57) **Abstract**

According to the present invention, there is provided a manufacturing method of a strained Si substrate including at least steps of: forming a lattice-relaxed SiGe layer on a silicon single crystal substrate; flattening a surface of the SiGe layer by CMP; and forming a strained Si layer on the surface of the flattened SiGe layer, wherein the method comprises steps of: subjecting the surface of the SiGe layer to SC1 cleaning, before forming the strained Si layer on the lattice-relaxed SiGe layer surface that is flattened; heat-treating the substrate having the SiGe layer after being subjected to SC1 cleaning in a hydrogen-containing atmosphere at 800°C or higher; immediately forming a protective Si layer on the SiGe layer surface on the heat-treated substrate, without lowering the temperature below 800°C after the heat treatment; and forming the strained Si layer on the surface of the protective Si layer at a temperature lower than the temperature of forming the protective Si layer. Thereby, a manufacturing method of a strained Si substrate having low surface roughness, threading dislocation density and low particle level can be provided.

## Description

### TECHNICAL FIELD

The present invention relates to a manufacturing method of a strained Si substrate of a bulk type or SOI type used for a high-speed MOSFET.

### BACKGROUND ART

In a strained Si substrate of a bulk type where a SiGe layer with graded concentration having an increased Ge concentration with increased thickness is formed on a Si substrate, a SiGe layer with constant concentration having a constant Ge concentration is formed thereon, and a Si layer is further formed thereon, since the Si layer is formed on the SiGe layer having a greater lattice constant than that of Si, the lattice constant of the Si layer is extended (tensile strain is caused), so that strain is generated. It is known that when the lattice constant of the Si layer in the device forming area is thus extended, mobility of electrons and holes is improved, which contributes to achieving high-performance of MOSFET (Metal Oxide Semiconductor Field Effect Transistor).
In the strained Si substrate, however, since dislocation is generated on the SiGe layer due to the difference in lattice constant between the Si substrate and the SiGe layer to be deposited on its surface, irregularities (cross-hatching patterns) are caused on the surface of the SiGe layer, so that a strained Si substrate with a sufficient high quality has not been obtained yet.

As a measure to improve this problem, there has been disclosed a method for improving threading dislocation density and surface roughness by flattening the irregular surface by performing CMP (Chemical Mechanical Polishing) or the like at least once during formation of the SiGe layer with graded concentration (See for example publication of Unexamined Japanese Patent Application No. 2000-513507). There has been also disclosed a method that after the SiGe layer is formed, CMP is performed for irregularities on its surface, then polishing and subsequently SC1 cleaning are performed so as to suppress threading dislocation and reduce its surface roughness of the strained Si layer which is to be formed on the resulting SiGe layer (See for example publication of Unexamined Japanese Patent Application No. 2002-289533).

However, in both of the methods disclosed in the publication of Unexamined Japanese Patent Application No. 2000-513507 and in the publication of Unexamined Japanese Patent Application No. 2002-289533, deterioration of the surface roughness and the increase in the threading dislocation density are induced during epitaxial growth (hereinafter referred to as epi-growth) of the strained Si on the SiGe layer surface, specifically in the heat-treatment processes both in removing native oxide film and in epi-growth of the strained Si, so that the methods are insufficient for obtaining a high-quality strained Si substrate.
For this reason, the epi-growth of the strained Si on the SiGe layer surface is preferably performed at as low a temperature as possible. Since the step of removing the native oxide film on the SiGe layer surface especially requires the highest temperature during the epi-growth of the strained Si, how to lower the temperature in the process is a key issue.

As a conventional method for lowering the temperature, after forming the SiGe layer, HF cleaning is performed as the last wafer cleaning step to remove the native oxide film, and then epi-growth of the strained Si is performed as soon as possible. Namely, if the native oxide film can be formed thinly, it can be removed at a low temperature, so that epi-growth of the strained Si can be performed by suppressing the deterioration of surface roughness of the SiGe layer.

The process including HF cleaning at the last step, however, has a fundamental problem that particles tend to be attached, so that a strained Si substrate having a poor particle level is generated.

For solving this problem, publication of Unexamined Japanese Patent Application No. 2001-148473 discloses a method that after forming the SiGe layer, its surface is etched by means of a HF+HNO₃ etchant for reducing the thickness of the SiGe layer to a desired thickness, the resulting surface is SC2-cleaned for forming a protective oxide film on it, and the protective oxide film is subjected to heat treatment in the high vacuum for removing it, and subsequently a strained Si layer is formed at 650°C on the surface of the SiGe layer. Publication of Unexamined Japanese Patent Application No. 2003-31495 discloses a method that after forming the SiGe layer, a protective layer (Si layer, for example) is deposited on the surface of the SiGe layer followed by that a strained Si layer is formed by means of epi-growth.

However, with the method disclosed in the above-mentioned publication of Unexamined Japanese Patent Application No. 2001-148473, the particles attached on the surface are not removed enough, and the above-mentioned Publication of Unexamined Japanese Patent Application No. 2003-31495 does not mention a cleaning step at all. Therefore, it is difficult with both of the two methods to obtain a strained Si substrate having a sufficient surface roughness and a low particle level.

### DISCLOSURE OF INVENTION

The present invention has been made in view of the above-mentioned circumstances, and an object of the present invention is to provide a manufacturing method of a strained Si substrate having low surface roughness, threading dislocation density and particle level.
Another object of the present invention is to provide a manufacturing method of a high-quality Strained Silicon On Insulator (SSOI) substrate using this strained Si substrate.

In order to achieve the objects, according to the present invention, a manufacturing method of a strained Si substrate including at least steps of: forming a lattice-relaxed SiGe layer on a silicon single crystal substrate; flattening a surface of the SiGe layer by CMP; and forming a strained Si layer on the surface of the flattened SiGe layer, wherein the method comprises steps of: subjecting the surface of the SiGe layer to SC1 cleaning, before forming the strained Si layer on the lattice-relaxed SiGe layer surface which is flattened; heat-treating the substrate having the SiGe layer after being subjected to SC1 cleaning in a hydrogen-containing atmosphere at 800°C or higher; immediately forming a protective Si layer on the SiGe layer surface on the heat-treated substrate, without lowering the temperature below 800°C after the heat treatment; and forming the strained Si layer on the surface of the protective Si layer at a temperature lower than the temperature of forming the protective Si layer is provided.

Thus by forming a lattice-relaxed SiGe layer on a silicon single crystal substrate, and by flattening the surface of the SiGe layer by CMP before epi-growth of a strained Si on its surface, cross-hatching, dislocation and the like on the surface of the lattice-relaxed SiGe layer can be eliminated. Then by SC1 cleaning (cleaning in an aqueous solution of NH₄OH and H₂O₂), polishing agent used in the CMP and particles attached on the surface in CMP can be removed efficiently. In addition, native oxide film, which is useful for preventing impurities and the like from attaching on the surface, is formed on the surface of SiGe layer by the SC1 cleaning. Then, immediately after removing this native oxide film in a hydrogen-containing atmosphere at 800°C or higher (hereinafter, sometimes simply referred to as H₂ bake), a protective Si layer is formed on the SiGe layer without lowering the temperature below 800°C. Thereby, the deterioration of surface roughness (haze) of the SiGe layer surface can be minimized at H₂ bake. In the following epi-growth of the strained Si, since strained Si is epitaxially grown on a surface with low surface roughness and a small number of particles, a strained Si layer with a good-quality can be obtained. Here, the epi-growth of the strained Si is performed at a lower temperature than that of forming the protective Si layer because the lower temperature allows the Ge concentration in the strained Si layer to be reduced.

Here, SC2 cleaning is preferably performed after subjecting the surface of the lattice-relaxed SiGe layer to SC1 cleaning.

By thus SC2-cleaning (cleaning in an aqueous solution of HC1 and H₂O₂) after being subjected to SC1 cleaning, heavy metals and the like attached on the surface of the SiGe layer can be removed, so that a surface with less impurities can be obtained.

Here, an etching amount in cleaning the surface of the lattice-relaxed SiGe layer is preferably 3 nm or less in total.

Since SiGe has a higher etching rate than Si, its surface roughness tends to be deteriorated. However, if the etching removal of the SiGe layer to be etched in the cleaning of the surface of the SiGe layer is set to be 3 nm or less in total, the deterioration of the surface roughness can be suppressed at minimum.

In addition, the protective Si layer has preferably a thickness of 10 nm or less.

Since this protective Si layer is formed only for preventing the deterioration of the SiGe surface roughness until the temperature is lowered to a predetermined value and the strained Si is formed, it is sufficient to form it with a thickness of 10 nm or less. With a thicker protective film, misfit dislocation would be generated in a large number, so that the film quality might be deteriorated.

Moreover, a surface after forming the strained Si layer is preferably etched.

By thus etching the surface of the strained Si layer after forming the strained Si layer, Ge piled up on the surface region can be removed.

In addition, after the heat treatment in the hydrogen-containing atmosphere, the protective Si layer is preferably formed on the heat-treated surface of the SiGe layer at the same temperature as that for the heat-treating temperature.

By thus subsequently forming the protective Si layer at the same temperature as that for the heat treatment in the hydrogen-containing atmosphere, the time period of exposing the bared surface of the SiGe layer can be minimized.

Furthermore, a manufacturing method of a strained Si substrate is provided wherein a strained Si substrate of SOI type is manufactured by means of a wafer bonding method, the strained Si substrate manufactured by either of the above-mentioned manufacturing methods being used as a bond wafer.

If a strained Si substrate of SOI type is fabricated by the wafer bonding method where a strained Si substrate thus manufactured by a manufacturing method according to the present invention is used as a bond wafer and is bonded with a base wafer, a high-quality SSOI substrate can be obtained since the strained Si layer forming a device has a high quality.

In accordance with the present invention, a strained Si substrate having low threading dislocation density, surface roughness and particle level can be manufactured.
By employing the strained Si substrate as a device area (SOI layer) of a SOI type substrate, a high-quality SSOI substrate can be provided.

### BRIEF DESCRIPTION OF DRAWINGS

Figs. 1 are schematic views illustrating an example of manufacturing steps of a strained Si substrate according to the present invention;
Fig. 2 is a view showing particles attached on the wafer surface after being subjected to HF cleaning and SC1 cleaning, respectively;
Fig. 3A shows a haze level on the wafer before forming a protective Si layer;
Fig. 3B shows recipe of reaction at H₂ bake processing in Example 2;
Fig. 3C is a view showing haze levels on the wafer surface after removing native oxide film under various H₂ bake conditions shown in Example 2, respectively;
Fig. 4A shows a haze level on the wafer before forming a protective Si layer;
Fig. 4B shows recipe of reaction at epi-growth of the strained Si in Example 3;
Fig. 4C is a view showing various haze levels on the wafer surface depending on the presence/absence of the protective oxide film and depending on the temperature at growth of the strained Si, respectively; and
Figs. 5 are views showing measurement results of Ge depth profiles in a strained Si substrate according to the present invention.

### BEST MODE(S) FOR CARRYING OUT THE INVENTION

Conventionally, two parameters i.e., surface roughness and threading dislocation density have been incompatible, i.e., difficult to be satisfied simultaneously in manufacturing a strained Si substrate including at least a lattice-relaxed SiGe layer, because they tend to be in a trade-off relationship. In addition, particles attached on the surface during substrate formation must also be removed. Therefore, an efficient method for solving the above-mentioned three problems has been desired to be developed.

As a measure for solving the problems, it has been known that dislocation and surface roughness can be improved by polishing and flattening sufficiently the surface of a lattice-relaxed SiGe layer, and that particle level can be improved by sufficient cleaning after polishing. In combination of the above-mentioned methods, the inventors of the present invention considered to solve the above-mentioned three problems more efficiently further by appropriately controlling the conditions during epi-growth of the strained Si on the surface of the SiGe layer after cleaning, specifically at the steps of removing a native oxide film formed in the cleaning step by heat treatment (H₂ bake) in a hydrogen-containing atmosphere, of forming a protective Si layer immediately after the H₂ bake processing and of epitaxially growing the strained Si layer. The inventors have experimented and examined diligently, so that they have completed the present invention.

Hereinbelow, the present invention is specifically described with respect to embodiments in reference to the drawings, though the present invention is not limited to the description.

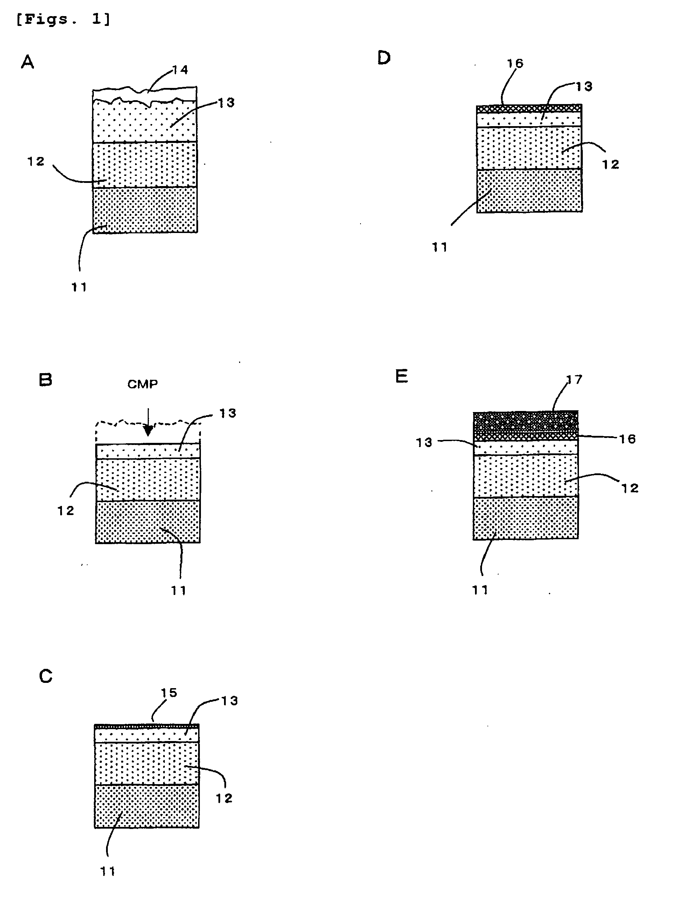

Figs. 1 are schematic views illustrating exemplary manufacturing steps of a strained Si substrate according to the present invention.
First, a Si single crystal substrate 11 with a sufficiently flat main surface is prepared. A manufacturing method of the Si single crystal substrate 11 and its plane orientation may be appropriately selected depending on a purpose, and it is not limited specifically. For example, CZ method or FZ method are generally employed for fabricating the Si single crystal.

Subsequently, a SiGe layer with graded concentration 12 is grown so that Ge concentration increases as its thickness on the surface of the Si single crystal substrate 11 increases. After the SiGe layer with graded concentration 12 is grown to a desired Ge concentration, a SiGe layer with constant concentration 13 having a constant Ge concentration is grown. As a result, a lattice-relaxed SiGe layer can be obtained.
A Si layer 14 may be deposited on the SiGe layer with constant concentration 13 in order to prevent the surface from being roughened (See Fig. 1A).

Since the surface roughness is deteriorated due to cross-hatching on the surface of the SiGe layer with constant concentration 13 (or on the surface of the Si layer 14), the surface is polished by CMP to flatten it (See Fig. 1B). Then, particles and the like generated during the polishing step by CMP are removed by subjecting the flattened substrate main surface 13 to SC1 cleaning. It is known that SC1 cleaning allows less particles to be attached and has characteristics of etching both Si and SiGe and of forming native oxide film 15 on the surface (See Fig. 1C). Since SiGe has a higher etching rate than Si, its surface roughness is easy to be deteriorated. In order to prevent the deterioration of the surface roughness, it is desirable to set an etching amount of the surface of the SiGe layer 13 after being polished to be 3 nm or less in total.
Care needs to be exercised in fabricating a SiGe layer with highly-concentrated Ge, since the etching rate due to SC1 becomes higher as the Ge concentration of the SiGe layer increases.

Next, the native oxide film 15 formed on the surface of the lattice-relaxed SiGe layer with constant concentration 13 by the above-mentioned SC1 cleaning is removed by H₂ bake by means of a CVD (Chemical Vapor Deposition) device of single wafer processing type under a reduced pressure at a predetermined temperature and for a predetermined time period. H₂ bake needs to be performed at least at 800°C or higher, preferably 900°C or higher.

It is known that surface roughness of the SiGe layer is likely to be deteriorated also by a high-temperature H₂ baking processing. Therefore, the heat treatment is preferably performed for as short a time period as possible. However, since the native oxide film should be removed completely in this step so as to obtain a strained Si layer with good crystallinity, appropriate values of time period and temperature which do not cause deterioration of the roughness and at the same time allow the native oxide film to be removed completely are needed. As will be explained in detail in the below-mentioned examples, the roughness of the SiGe surface is deteriorated quite slightly due to H₂ bake when the native oxide film remains on the surface, and the deterioration of the roughness (haze) can be prevented if a protective Si layer 16 is formed immediately after the native oxide film is removed (See Fig. 1D).

Since it is also important to form the protective Si layer 16 as soon as possible after removing the native oxide film 15 by H₂ baking processing, the protective Si layer 16 is preferably and effectively formed after removing the native oxide film without lowering the temperature below 800°C, but preferably keeping almost the same temperature as that for the H₂ bake.
As for forming the protective Si layer 16, trichlorosilane (TCS), dichlorosilane (DCS) or monosilane (SiH₄) is generally used as Si source gas. Since this protective Si layer 16 is formed almost only for the purpose of preventing the roughness on the surface of the SiGe layer 13 from being deteriorated from the time when the temperature is lowered to a predetermined value after removing the native oxide film until the strained Si layer 17 is completely formed, the thickness of 10 nm or less is enough. If it is greater, misfit dislocation is largely generated in the protective Si layer 16, so that the film quality may be deteriorated.

Subsequently, a strained Si is epitaxially grown on the protective Si layer 16 at a predetermined temperature. Here, in a case of the protective Si layer 16 being formed in advance, the haze is not deteriorated and the strained Si layer 17 can be epitaxially grown well even if epi-growth temperature is lowered at about 650°C (See Fig. 1E).
It is to be noted that epi-growth is performed at as low a temperature as possible, since Ge diffusion from the SiGe layer to the strained Si layer becomes remarkable with the temperature becoming higher.

As the last step for obtaining a desirable strained Si substrate, the surface of the strained Si layer 17 is preferably removed by etching with a predetermined thickness. Though it is explained in detail in the below-mentioned examples, this is preferably performed because Ge is piled up on the surface of the strained Si layer 17. Removing amount is preferably about 10 nm from the surface of strained Si layer 17.
If Ge remains deposited on the surface of strained Si layer, the strained amount of the strained Si is lowered afterward, and dielectric breakdown voltage characteristic is deteriorated if a part of the strained Si layer will be used as a gate oxide film.

Thus in accordance with a manufacturing method of a strained Si substrate according to the present invention, a strained Si substrate having low threading dislocation density, surface roughness and particle level can be manufactured with high productivity without complex steps, i.e., by polishing the surface of the SiGe layer by means of CMP, by subsequently SC1 cleaning, and by optimally controlling temperature and time period in heat treatment in a hydrogen-containing atmosphere for removing native oxide film formed during the SC1 cleaning, in formation of a protective layer, and in epitaxial growth of the strained Si layer.
In addition, removing by etching the surface of the strained Si layer of the strained Si substrate at a predetermined thickness allows obtaining a strained Si substrate with excellent characteristics.

Furthermore, a strained Si substrate according to the present invention is used as a bond wafer, and by a wafer bonding method, a silicon single crystal substrate (base wafer) with a oxide film being formed on its surface for example is bonded to the strained Si layer, where the surface with the oxide film being formed is sandwiched therebetween, and then thinning is performed by grinding, polishing or the like to the strained Si layer so as to obtain a high-quality Si wafer of SOI type.

Hereinbelow, the present invention will be described more specifically in reference to experimental examples of the present invention, though the present invention is not limited to the below-mentioned experimental examples.

A Si single crystal substrate 11 with a plane orientation of {100} manufactured by CZ method was prepared. This Si single crystal substrate 11 was carried into a CVD device of single wafer processing type so as to perform epitaxial growth of a SiGe layer using dichlorosilane and germanium tetrachloride as process gas, under conditions of 1000°C and 80 torr (about 11 kPa) as shown below. Namely, a SiGe layer with graded concentration 12 was grown at 2 µm by supplying dichlorosilane at a constant amount, i.e., 200 sccm, while the supplied amount of germanium tetrachloride was increased gradually from 0 g/min to 0.6 g/min so as to increase the Ge concentration from 0% to 21%, and subsequently a lattice-relaxed SiGe layer with constant concentration 13 was grown at 2 µm thereon by supplying dichlorosilane and germanium tetrachloride at 200 sccm and 0.6 g/min, respectively, so as to make the Ge concentration constant, i.e., 21%. On the surface of the SiGe layer with constant concentration 13, cross-hatching pattern and the like existed, so that the surface roughness was bad (See Fig. 1A).

This SiGe layer with constant concentration 13 was subjected to CMP with a removal stock of about 100 nm (See Fig. 1B). As the surface flatness of the SiGe layer with constant concentration 13 after polishing, the RMS roughness had 0.13 nm (measured area was 30 µm x 30 µm). This semiconductor substrate was measured by a particle measuring instrument with respect to haze on the entire surface of the SiGe layer with constant concentration 13, so that the haze condition was confirmed to be good.

In the below-mentioned experimental examples, thus processed substrates in each of which the SiGe layer with constant concentration 13 having Ge concentration of 21% was deposited and subsequently was subjected to CMP were used.

### Experimental Example 1

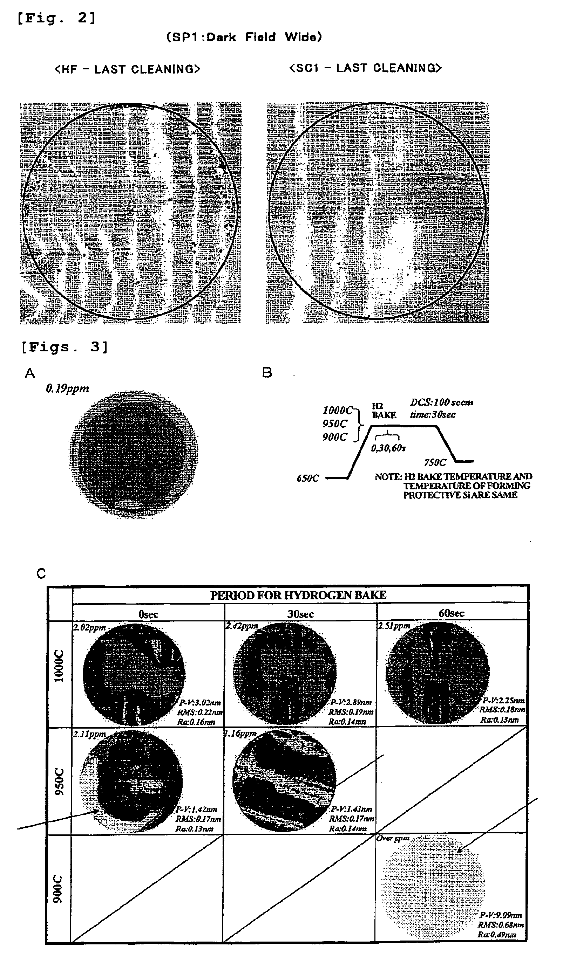

As the last cleaning step of a wafer surface for the semiconductor substrate after the CMP, HF finishing and SC1 finishing were compared (See Fig. 2).

1) The above-mentioned semiconductor substrate was subjected to SC1 cleaning in a mixed liquid of NH₄OH:H₂O₂:H₂O=1:1:5, DHF (5%) cleaning, and spin-drying at 76°C, and then was measured with respect to its particle level on the wafer surface by a particle measuring instrument (SP1, manufactured by KLA-Tencor Corporation) in a Dark Field Wide mode (See Fig. 2, left-hand side).
2) The above-mentioned semiconductor substrate was subjected to SC1 cleaning in a mixed liquid of NH₄OH:H₂O₂:H₂O=1:1:5, and spin-drying at 76°C, and then was measured with respect to its particle level on the wafer surface by a particle measuring instrument (SP1) in a Dark Field Wide mode (See Fig. 2, right-hand side).

As is also apparent from Fig. 2, when the wafer cleaning was finished with HF, particles were very easy to be attached.

### Experimental Example 2

With respect to the semiconductor substrate which was subjected to the above-mentioned CMP and to SC1-cleaning under conditions of the above-mentioned Experimental Example 1 as the last cleaning process of the wafer (as shown in Fig. 1C), H₂ bake was performed using a CVD device of single wafer processing type for the purpose of removing native oxide film 15 formed in the SC1 cleaning, under a reduced pressure at each of the below-mentioned temperatures for each of the below-mentioned time periods so as to examine the optimal conditions.

Under a reduced pressure of 80 torr (about 11 kPa), the H₂ bake temperature was raised from 650°C to 900°C, 950°C and 1000°C, respectively, and for each temperature case, H₂ bake processing was performed for a constant time period (0 second, 30 seconds and 60 seconds), respectively, and then the reaction using DCS (100 sccm) was performed at the same temperature as that for the H₂ bake for 30 seconds so as to form a protective Si layer 16. Then haze maps by a particle measuring instrument (SP1) were observed (See Fig. 3B and 3C).
It is to be noted that views for cases for 0 second and 30 seconds under a condition of 900°C are omitted since the native oxide film 15 was not removed by H₂ bake processing for 60 seconds. In a case under a condition of 950°C, since the native oxide film 15 could be almost completely removed by H₂ bake processing for 30 seconds, a view in a case of processing for 60 seconds was omitted.
As a comparative example, haze level after SC1 cleaning (before H₂ bake) is shown in Fig. 3A.

It is apparent from the present Experimental Example 2 that removal of the native oxide film 15 formed by SC1 cleaning needed to take a considerably long time period in a H₂ bake processing at 900°C or below. The native oxide film partially remained under a condition of 950°C and 0 second, while it could be removed almost completely when it was processed for 30 seconds at the same temperature. At 1000°C, the native oxide film could be confirmed to be completely removed while the temperature was raised. Therefore, the native oxide film could be removed completely with a processing time period of 0 second (in other words, only at the step of rising temperature until the temperature was raised from 650°C to 1000°C). In the cases of conditions of 1000°C and 30 seconds as well as 60 seconds, since the heat treatment continued although the native oxide film had been already completely removed and the SiGe layer was exposed, haze level was deteriorated depending on the processing time as shown in Fig. 3C.
It is to be noted that arrows in Fig. 3C show regions with the remaining native oxide film.
It is to be noted that in a case of DHF employed as the last cleaning step, H₂ bake at 810°C allowed the native oxide film to be removed.

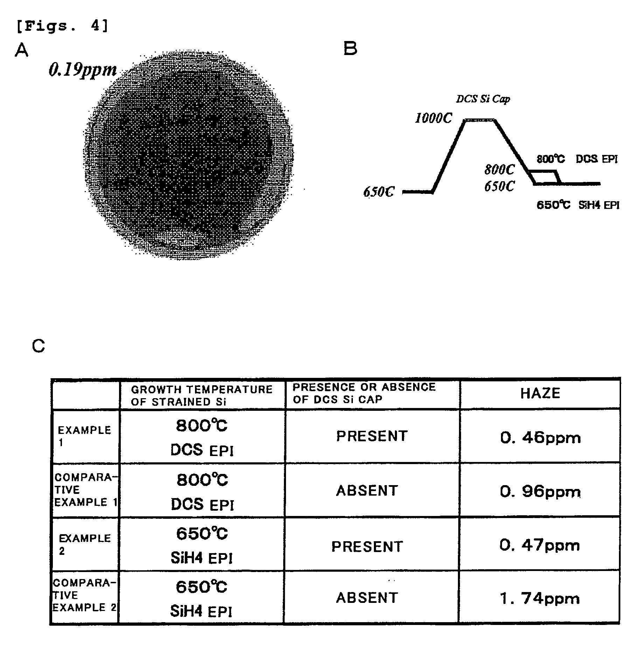

Accordingly, it is apparent that H₂ bake step for removing the native oxide film 15 was preferably performed at 950°C for 30 seconds, or alternatively at 1000°C for 0 second.
In the following examples and comparative examples, H₂ bake was performed by setting the conditions as 1000°C and 0 second. Then, a relationship of presence/absence of the formation of the protective Si layer 16, the temperature of epi-growth of the strained Si, and the haze level on the wafer surface was investigated (See Figs. 4).

### Examples 1 and 2, and Comparative Examples 1 and 2

In Examples 1 and 2 shown in Fig. 4C, immediately after H₂ bake, a protective Si layer 16 was formed with a thickness of 5 nm, then the temperature was lowered to 800°C or 650°C which was a temperature for growing a strained Si, and then a strained Si layer 17 was epitaxially grown with a thickness of 70 nm. In Comparative Examples 1 and 2, after H₂ bake, still in H₂ atmosphere, the temperature was lowered to 800°C or 650°C which was a temperature for growing a strained Si, and then a strained Si layer 17 was epitaxially grown with the thickness of 70 nm. Haze level under each condition was measured.
As a reference, Fig. 4A shows a haze level on a wafer surface before H₂ bake (0.19 ppm). Fig. 4B shows recipe of the above-mentioned reaction, and it shows specifically that a wafer was inserted into a CVD device at 650°C, that temperature was raised to 1000°C in a hydrogen atmosphere, that immediately DCS was flowed for three seconds so as to form a protective Si layer (Si Cap), that subsequently the temperature was lowered to 800°C or 650°C, respectively, and that DCS was used in a case of 800°C and SiH₄ was used in a case of 650°C, respectively so as to form a strained Si layer.

In both of the present Comparative Examples 1 and 2, where the temperature was lowered after H₂ bake to 800°C or below without forming the protective Si layer 16, haze level was deteriorated. Especially in Comparative Example 2, where the epi-growth temperature of the strained Si was 650°C, the haze level was deteriorated by 1.5 ppm or more compared to the reference (in Fig. 4A). In Comparative Example 1, where the epi-growth temperature of the strained Si was 800°C, the haze level was about 1 ppm.
On the other hand, in each of the cases where the protective Si layer 16 was formed before the epi-growths of the strained Si, i.e., in both cases of epi-growth at 800°C (Example 1) and epi-growth at 650°C (Example 2), the haze level was kept at 0.5 ppm or below, so that it is shown that the protective Si layer 16 could remarkably suppress the deterioration of the haze level.

### Example 3

In the above-mentioned Examples 1 and 2, effectiveness of the protective Si layer 16 was demonstrated. However, the optimal temperature condition in the epi-growth of the strained Si cannot be determined yet. In the present Example, Ge profiles in the depth direction of the strained Si substrate according to the present invention were measured for each epi-growth temperature of the strained Si.

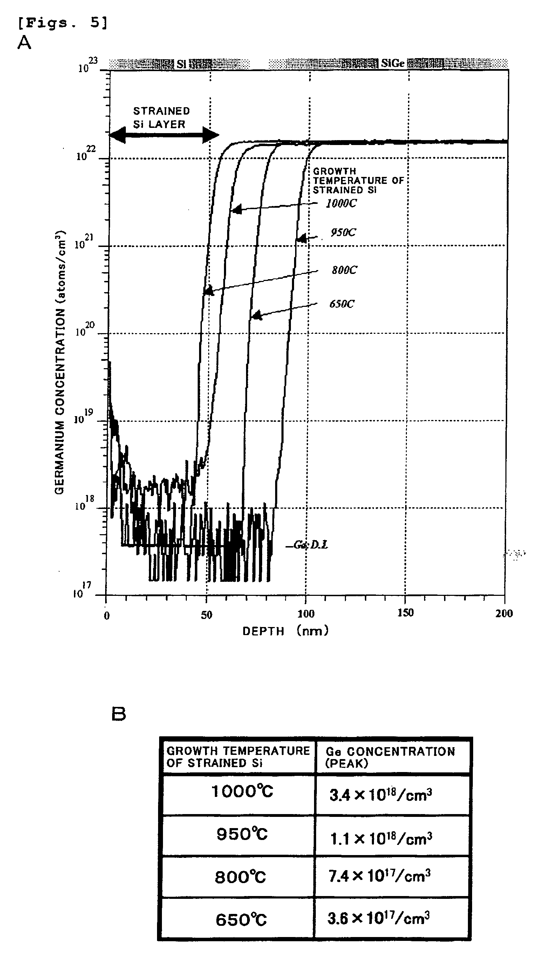

In the present Example 3, as in the above-mentioned Examples 1 and 2, after native oxide film 15 on the SiGe surface was removed at 1000°C for 0 second, a protective Si layer 16 was formed, then the temperature was lowered to each of 650°C, 800°C, 950°C, and 1000°C, and a Ge profile for each sample with the strained Si layer 17 which was epitaxially grown was measured (See Fig. 5A).

The results from the above-mentioned profiles are as follows:
The Ge concentration in the strained Si layer 17 tended to increase as the epi-growth temperature of the strained Si increases. It could be suppressed below 1x10¹⁸/cm³ at a temperature of 800°C or below. Under conditions of 950°C and 1000°C, on the other hand, the Ge concentration was 10¹⁸/cm³ or greater in either case (See Fig. 5B). It was also confirmed that Ge was piled up on the surface of the strained Si layer 17 (See Fig. 5A). The haze level on the strained Si layer 17 was 0.5 ppm or below in either case, which was good.

Consequently, it is apparent from the results of the present Example 3 and the above-mentioned Examples 1 and 2 that epi-growth of the strained Si is preferably performed at as low a temperature as possible, and especially it is optimally performed at 650°C. Device characteristic is not deteriorated if Ge piled up on the surface is removed by etching. It is sufficient to remove 10 nm, which is apparent from Fig. 5A.

As mentioned above, it is apparent from the results of Experimental Examples 1 and 2, Examples 1 to 3 and Comparative Examples 1 and 2 that a wafer surface having a low particle level can be obtained by stacking a lattice-relaxed SiGe layer on a silicon single crystal substrate and by flattening the surface of the SiGe layer by CMP followed by SC1 cleaning. It is also apparent that a high-quality strained Si substrate having low threading dislocation density, haze level (surface roughness) and particle level can be obtained by subsequently removing the native oxide film formed at the SC1 cleaning by means of heat-treatment in a hydrogen-containing atmosphere under conditions of 950°C and 30 seconds or of 1000°C and 0 second, by forming a protective Si layer at the same temperature as that for the heat treatment, and by epi-growing a strained Si layer on the protective Si layer in a lowered temperature to 650°C.

The present invention is not limited by the foregoing embodiments. The foregoing embodiments are merely illustrative, and any embodiment that has a structure substantially identical to the technical concept disclosed in the claims of the invention, and provides a similar effect is encompassed within the technical scope of the invention.

## Claims

1. A manufacturing method of a strained Si substrate including at least steps of: forming a lattice-relaxed SiGe layer on a silicon single crystal substrate; flattening a surface of the SiGe layer by CMP; and forming a strained Si layer on the surface of the flattened SiGe layer, wherein the method comprises steps of: subjecting the surface of the SiGe layer to SC1 cleaning, before forming the strained Si layer on the lattice-relaxed SiGe layer surface that is flattened; heat-treating the substrate having the SiGe layer after being subjected to SC1 cleaning in a hydrogen-containing atmosphere at 800°C or higher; immediately forming a protective Si layer on the SiGe layer surface on the heat-treated substrate, without lowering the temperature below 800°C after the heat treatment; and forming the strained Si layer on the surface of the protective Si layer at a temperature lower than the temperature of forming the protective Si layer.

2. The manufacturing method of a strained Si substrate according to claim 1, wherein SC2 cleaning is performed after subjecting the surface of the lattice-relaxed SiGe layer to SC1 cleaning.

3. The manufacturing method of a strained Si substrate according to claim 1 or 2, wherein an etching amount in cleaning the surface of the lattice-relaxed SiGe layer is 3 nm or less in total.

4. The manufacturing method of a strained Si substrate according to any one of claims 1 to 3, wherein the protective Si layer has a thickness of 10 nm or less.

5. The manufacturing method of a strained Si substrate according to any one of claims 1 to 4, wherein a surface after forming the strained Si layer is etched.

6. The manufacturing method of a strained Si substrate according to any one of claims 1 to 5, wherein after the heat treatment in the hydrogen-containing atmosphere, the protective Si layer is formed on the heat-treated surface of the SiGe layer at the same temperature as that for the heat-treating temperature.

7. A manufacturing method of a strained Si substrate, wherein a strained Si substrate of SOI type is manufactured by means of a wafer bonding method, the strained Si substrate manufactured by the manufacturing method according to any one of claims 1 to 6 being used as a bond wafer.
